# EUROPÄISCHE PATENTANMELDUNG

(11) **EP 1 681 912 A2**
(43) Veröffentlichungstag der Anmeldung: **19.07.2006**
(21) Anmeldenummer: 05112239.8
(22) Anmeldetag: 15.12.2005
(51) Int. Cl.: H05K 13/08

(54) **Vorrichtung zum homogenen Beleuchten von Objekten**

(30) Priorität: 17.01.2005 DE 102005002194
(71) Anmelder: SIEMENS AKTIENGESELLSCHAFT, 80333 München (DE)
(72) Erfinder: Besch, Karl-Heinz, 82140, Olching (DE); Schauer, Christian, 81371, München (DE)

(57) **Zusammenfassung**

Die Erfindung schafft eine Beleuchtungsvorrichtung (100), welche eine Mehrzahl von Leuchtelementen (111) zum Aussenden von Beleuchtungslicht (112) und ein optisches Element (120) zum Lenken des Beleuchtungslichtes (112) auf einen vorgegebenen Messbereich (150) aufweist. Das optische Element 120 umfasst ein diffus streuendes Material und weist eine Strukturierung (123) auf, welche derart ausgebildet ist, dass das ausgesandte Beleuchtungslicht (112) gezielt auf den Messbereich (150) gelenkt wird. Das optische Element (120) dient der Fokussierung und der Homogenisierung des Beleuchtungslichts, so dass im Ergebnis das Objekt (160) unter einer Vielzahl von verschiedenen Winkeln beleuchtet werden kann. Die durch die Strukturierung (125) hervorgerufene Fokussierung des Beleuchtungslichts (112) beruht auf Refraktionseffekten an verschiedenen kleinen Grenzflächen der Strukturierung bzw. auf Interferenzeffekten zwischen verschiedenen Teilstrahlen des von einem Leuchtelement (111) ausgesandten Beleuchtungslichts (112). Bevorzugt weist das optische Element (120) einen transparenten Bereich (130) auf, so dass durch das optische Element (120) hindurch ein Abbildungsstrahlengang zwischen dem Objekt (160) und einer Kamera entlang einer optischen Achse (125) geführt werden kann, auf welcher an einer der dem Objekt gegenüberliegenden Seite ein Kamerasensor (170) angeordnet ist.

## Beschreibung

Die Erfindung betrifft eine Vorrichtung zum homogenen und gleichzeitig intensiven Beleuchten von einem in einer Objektebene angeordneten Objekt, insbesondere von einem elektronischen Bauelement und/oder einer auf einem Bauelementeträger aufgebrachten Markierung.

Bei der automatischen Bestückung von Bauelementeträgern in so genannten Bestückautomaten werden Bauelemente von einer Bauelement-Zuführeinrichtung an bestimmten Abholpositionen bereitgestellt und dort von einem Bestückkopf abgeholt, welcher mittels eines Positioniersystems innerhalb eines Arbeitsbereiches positionierbar ist. Die abgeholten Bauelemente werden von dem Bestückkopf zu einer Bestückposition transportiert und auf dem Bauelementeträger an durch entsprechende Anschlussflächen definierte Einbaupositionen aufgesetzt.

Aufgrund der zunehmenden Miniaturisierung von elektronischen Bauelementen ist ein präziser Bestückvorgang nur durch eine genaue optische Lagevermessung der von dem Bestückkopf aufgenommenen Bauelemente möglich. Ebenso ist eine präzise Lagevermessung des zu bestückenden Bauelementeträgers erforderlich, damit von dem Bestückkopf die richtigen Bestückpositionen präzise angefahren werden können. Die Lagevermessung von Bauelementeträgern erfolgt üblicherweise anhand spezieller an den jeweiligen Bauelementeträgern angebrachten Markierungen.

Ein moderner Bestückautomat zeichnet sich jedoch nicht nur durch eine hohe Bestückgenauigkeit, sondern auch durch eine hohe Bestückleistung aus. Unter dem Begriff Bestückleistung ist in diesem Zusammenhang die maximale Anzahl an Bauelementen zu verstehen, die innerhalb einer bestimmten Zeiteinheit von der Bauelement-Zuführeinrichtung abgeholt und auf der Bauelementeträger aufgesetzt werden kann.

Um bei einer hohen Bestückleistung gleichzeitig eine hohe Bestückgenauigkeit bei einer ständig größer werdenden Anzahl von unterschiedlichen Typen von Bauelementen mit unterschiedlichen optischen Eigenschaften zu erreichen, ist neben einem hochwertigen Kamerasystem auch eine Beleuchtungsvorrichtung erforderlich, welche die zu erfassenden Objekte möglichst homogen und mit einer hohen Beleuchtungsstärke beleuchtet.

Zur Erzielung einer hohen Beleuchtungsstärke werden als Lichtquellen üblicherweise eine Mehrzahl von hell leuchtenden Leuchtdioden verwendet, welche das jeweilige Beleuchtungsfeld unter verschiedenen Winkeln beleuchten. Da hell leuchtende Leuchtdioden jedoch üblicherweise aus einer nahezu punktförmigen Fläche abstrahlen, werden zur Homogenisierung des Beleuchtungslichts und damit zur Vermeidung von ungünstigen kleinflächigen Beleuchtungsspots Diffusorelemente verwendet. Diese haben jedoch den Nachteil, dass sie die Intensität der resultierenden Beleuchtung signifikant verringern. Ein weiterer Nachteil der Verwendung von bekannten Diffusorelementen besteht darin, dass diese die Montage einer entsprechenden Beleuchtungsvorrichtung erschweren und zudem die Bauform der Beleuchtungsvorrichtung hinsichtlich der Kompaktheit deutlich einschränken.

Der Erfindung liegt die Aufgabe zugrunde, eine Vorrichtung zum Beleuchten von einem in einer Objektebene angeordneten Objekt zu schaffen, welche auf einfache Weise in einer kompakten Bauform montiert werden kann und zudem eine homogene Beleuchtung mit intensivem Beleuchtungslicht ermöglicht.

Diese Aufgabe wird gelöst durch eine Vorrichtung zum Beleuchten von einem in einer Objektebene angeordneten Objekt, insbesondere zum Beleuchten eines elektronischen Bauelements und/oder einer auf einem Bauelementeträger aufgebrachten Markierung, mit den Merkmalen des unabhängigen Anspruchs 1. Die erfindungsgemäße Beleuchtungsvorrichtung umfasst eine Mehrzahl von Leuchtelementen, welche zum Aussenden von Beleuchtungslicht eingerichtet sind. Ferner umfasst die Beleuchtungsvorrichtung ein optisches Element zum Lenken des Beleuchtungslichts auf einen vorgegebenen Messbereich in der Objektebene, wobei das optische Element ein diffus streuendes Material umfasst und eine Strukturierung aufweist, welche derart ausgebildet ist, dass das von den Leuchtelementen ausgesandte Beleuchtungslicht gezielt auf den Messbereich gelenkt wird.

Der Erfindung liegt die Erkenntnis zugrunde, dass das optische Element sowohl zur Fokussierung des Beleuchtungslichts als auch zum Streuen des Beleuchtungslichts und damit zur Erzielung einer homogenen Beleuchtung dient. Die Fokussierung kann dabei in ähnlicher Weise wie bei einer Fresnel-Linse erfolgen, bei der das von der Mehrzahl von Leuchtelementen ausgesandte Beleuchtungslicht jeweils durch Refraktion und/oder durch Interferenzeffekte auf einen Bereich gerichtet wird, welcher üblicherweise kleiner ist als die flächige Ausdehnung des optischen Elements.

Das diffus streuende Material kann beispielsweise eine Kunststofffolie sein, welche unmittelbar auf den Grundkörper des optischen Elements aufgebracht ist. Die Leuchtelemente sind bevorzugt hell leuchtende Leuchtdioden, welche vom selben Typ sein können und Beleuchtungslicht mit einer einheitlichen spektralen Verteilung emittieren. Ebenso können jedoch auch verschiedene Leuchtelemente mit unterschiedlichen Emissionswellenlängen eingesetzt werden und somit die spektrale Verteilung des Beleuchtungslichts insbesondere bei einer individuellen Ansteuerung der unterschiedlichen Leuchtelemente optimal an die optischen Eigenschaften des jeweils zu beleuchtenden Objekts angepasst werden.

Gemäß Anspruch 2 ist das optische Element einstückig aus einem diffus streuenden Material hergestellt, welches bevorzugt Kunststoff ist. Heutzutage stehen eine Vielzahl von verschiedenen Kunststoffsorten wie beispielsweise Plexiglas (PMMA) oder Polycarbonat zur Verfügung, welche eine optimale Anpassung des optischen Elements an die spektrale Verteilung des Beleuchtungslichts und an das jeweils optimale Streuvermögen erlauben.

Gemäß Anspruch 3 wird die Strukturierung durch eine Variation der Dicke des optischen Elements realisiert. Dies hat den Vorteil, dass das optische Element im Rahmen einer einfachen und billigen Herstellung über ein Spritzgießverfahren oder ein Heißprägeverfahren mit einem entsprechenden Granulatmaterial hergestellt werden kann.

Gemäß Anspruch 4 wird die Strukturierung durch eine Variation des lokalen Brechungsindexes des optischen Elementes realisiert. Somit kann das optische Element auch in einer kompakten Bauform hergestellt werden, welche geometrische Abmessungen wie eine planparallele Platte aufweist und welche aufgrund einer Unanfälligkeit für Verschmutzungen eine besonders einfache Handhabung und Montage der Beleuchtungsvorrichtung ermöglicht.

Die Anordnung der Leuchtelemente in einer Ebene nach Anspruch 5 hat den Vorteil, dass sämtliche Leuchtelemente auf einer gemeinsamen Platine angeordnet werden können und somit die Montage der Beleuchtungsvorrichtung weiter vereinfacht wird.

Gemäß Anspruch 6 weist das optische Element eine zu einer optischen Achse symmetrische Form auf und die Leuchtelemente sind symmetrisch zu dieser optischen Achse angeordnet. Dies ermöglicht auf vorteilhafte Weise eine besonders homogene Beleuchtung ohne eine unerwünschte Vorzugsrichtung und erlaubt somit eine besonders genaue Erfassung des beleuchteten Objekts mit einer entsprechenden Kamera.

Gemäß der vorteilhaften Ausführungsform nach Anspruch 7 weist das optische Element einen transparenten Bereich auf. Dieser kann auf vorteilhafte Weise zur Führung eines Abbildungsstrahlengangs durch das optische Element hindurch für eine optische Abbildung zwischen dem zu erfassenden Objekt und einer Kamera verwendet werden.

Gemäß Anspruch 8 ist der transparente Bereich eine Aussparung, eine planparallele Platte oder eine Abbildungsoptik. Bevorzugt befindet sich der transparente Bereich in der Mitte des optischen Elements und ist symmetrisch um die optische Achse herum angeordnet. Die Ausbildung des transparenten Bereiches in Form einer Abbildungsoptik hat den Vorteil, dass das optische Element zusätzlich zu den oben genannten Eigenschaften bezüglich der Homogenisierung und der Fokussierung des Beleuchtungslichts noch eine weitere Eigenschaft aufweist. Diese besteht darin, dass über das optische Element der Messbereich auf eine Kamera abgebildet werden kann, wobei sich der Messbereich und die Kamera auf unterschiedlichen Seiten des optischen Elements befinden. Somit ist zur Realisierung eines voll funktionsfähigen Kamerasystems neben einer entsprechenden Kamera keine weitere Abbildungsoptik zur Abbildung des Messbereichs auf einen Sensor der Kamera erforderlich. Damit kann nicht nur die Beleuchtungsvorrichtung, sondern auch ein gesamtes Kamerasystem innerhalb einer kompakten Bauform realisiert werden.

Weitere Vorteile und Merkmale der vorliegenden Erfindung ergeben sich aus der folgenden beispielhaften Beschreibung einer derzeit bevorzugten Ausführungsform.

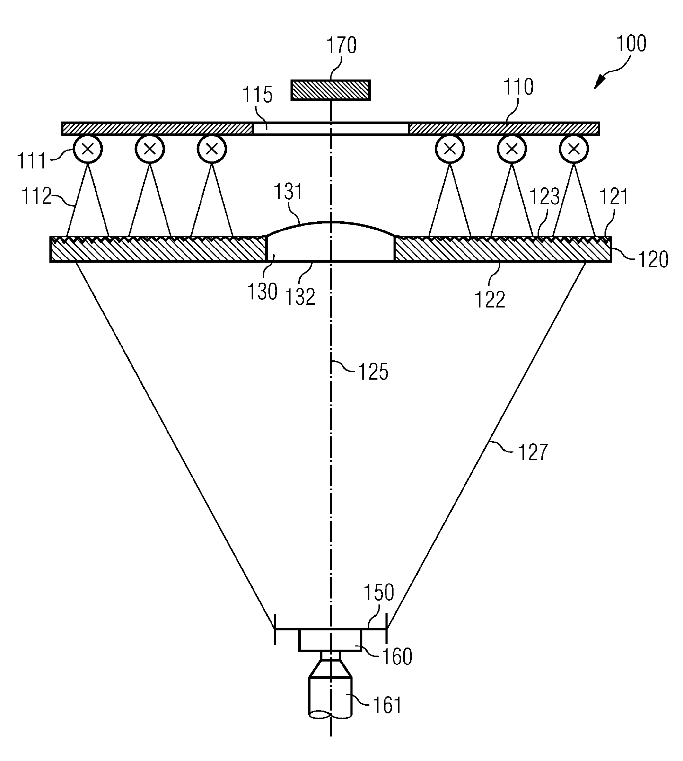

In der Zeichnung zeigt in schematischer Darstellung die einzige Figur die Beleuchtung eines Bauelements durch eine Beleuchtungsvorrichtung und die Erfassung des beleuchteten Bauelements durch eine Kamera.

Die Figur zeigt eine Beleuchtungsvorrichtung 100, welche in einem nicht dargestellten Gehäuse eine Platine 110 und ein optisches Element 120 aufweist. Die Platine 110 dient als gemeinsamer Schaltungsträger für eine Mehrzahl von Leuchtdioden 111, welche beispielsweise mittels eines SMD (Surface Mount Device)-Bestückverfahrens auf der Platine 110 angebracht und über nicht dargestellte Verbindungsleitungen mit einer elektronischen Treiberschaltung (ebenfalls nicht dargestellt) verbunden sind. Die Treiberschaltung kann ebenfalls auf der Platine 110 ausgebildet sein. Die Leuchtdioden 111 senden jeweils innerhalb eines bestimmten Öffnungswinkels Beleuchtungslicht 112 aus, welches auf eine Oberseite 121 des optischen Elements trifft.

Die Oberseite 121 weist eine Strukturierung 123 auf, welche dafür sorgt, dass unterschiedliche Teilstrahlen eines von einer Leuchtdiode 111 emittierten Beleuchtungslichts 112 infolge von Refraktionseffekten an den unterschiedlichen Grenzflächen des optischen Elements 120 unterschiedlich gebrochen werden. Die Strukturierung 123 ist dabei derart ausgestaltet, dass das austretende Beleuchtungslicht bevorzugt auf einen Messbereich 150 gelenkt wird. Die damit verbundene Fokussierung des von den Leuchtdioden 111 ausgesandten Beleuchtungslichts 112 ist schematisch durch einen Beleuchtungskegel 127 dargestellt, welcher die gesamte Bandbreite an möglichen Beleuchtungswinkeln verdeutlicht.

Es wird darauf hingewiesen, dass die Strukturierung 123 auch bei einer gleichmäßigen Dicke des optischen Elements 120 erreicht werden kann. Zur Erzielung von unterschiedlichen optischen Weglängen kann auch eine Variation von Brechungsindizes beitragen, durch die ebenfalls eine Fortpflanzung des Beleuchtungslichts bevorzugt hin zu dem Messbereich 150 erzielt werden kann. Die Strukturierung 123 ist in jedem Fall derart gewählt, dass das von allen Leuchtdioden 111 ausgesandte Beleuchtungslicht 112 bevorzugt auf den Messbereich 150 gelenkt wird.

Es wird darauf hingewiesen, dass die Fokussierung des Beleuchtungslichts auch durch eine Strukturierung 123 erreicht werden kann, welche nicht aufgrund von Interferenzeffekten, sondern aufgrund von unterschiedlicher Refraktion von einzelnen Teilstrahlen an unterschiedlichen schräg verlaufenden Grenzflächen eine entsprechende Lichtablenkung bewirkt.

Ferner wird darauf hingewiesen, dass die Strukturierung auch an der Unterseite 122 oder an beiden Seiten des optischen Elements 120 vorgesehen sein kann.

Die Beleuchtungsvorrichtung 100 weist eine optische Achse 125 auf, welche sowohl für die Platine 110 als auch für das optische Element 120 eine Symmetrieachse darstellt. Sowohl die Platine 110 als auch das optische Element 120 mit der Strukturierung 123 weisen bezüglich der optischen Achse 125 eine Symmetrie auf und können beispielsweise eine achteckige Form haben. Die auf der Platine 110 aufgebrachten Leuchtdioden 111 sind derart angeordnet, dass innerhalb der zur Verfügung stehenden Fläche eine maximale Anzahl an Leuchtdioden 111 vorhanden ist.

Wie aus der Figur ersichtlich, kann die Beleuchtungsvorrichtung 100 auf vorteilhafte Weise zur Beleuchtung eines in den Messbereich 150 gebrachten Bauelementes 160 verwendet werden, welches von einem Sauggreifer 161 gehalten wird. Derartige Sauggreifer 161 sind typischerweise an Bestückköpfen angebracht und dienen dem Transport von Bauelementen von einer Abholposition einer Bauelement-Zuführeinrichtung hin zu einer Aufsetzposition auf einem zu bestückenden Bauelementeträger.

Um das Bauelement 160 mittels einer Kamera zu erfassen, welche einen CCD-Sensor oder einen CMOS-Sensor 170 aufweist, ist in der Platine 110 eine Aussparung 115 vorgesehen, die ebenfalls symmetrisch zu der optischen Achse 125 angeordnet ist. Die optische Achse 125 stellt eine Symmetrieachse sowohl für die Beleuchtung als auch für den Abbildungsstrahlengang zwischen dem zu erfassenden Bauelement 160 und dem CMOS-Sensor 170 dar.

Da eine optische Abbildung durch ein diffus streuendes Material nicht möglich oder zumindest erheblich erschwert ist, weist das optische Element 120 einen transparenten Bereich 130 auf, welcher ebenfalls symmetrisch zu der optischen Achse 125 ausgebildet ist. Gemäß dem hier dargestellten Ausführungsbeispiel weist der transparente Bereich 130 eine gewölbte Oberseite 131 auf, welche aufgrund ihrer refraktiven Eigenschaften wie eine Abbildungsoptik wirkt, welche für eine optische Abbildung des Bauelements 160 auf den CMOS-Sensor 170 erforderlich ist. Demzufolge dient das optische Element 120 nicht nur der Fokussierung und der Homogenisierung des Beleuchtungslichts 112, sondern der mittige transparente Bereich 130 des optischen Elements 120 stellt zusätzlich eine Abbildungsoptik dar. Somit ist zur Erfassung des Bauelements 160 keine weitere Abbildungsoptik erforderlich und die Kamera kann in Verbindung mit der Beleuchtungsvorrichtung 100 in einer kompakten Bauweise realisiert werden.

Selbstverständlich könnte auch eine untere Grenzfläche 132 des transparenten Bereichs 130 gewölbt sein, so dass der transparente Bereich 130 effektiv eine bikonvexe oder auch eine beliebige andere Linsenform aufweist.

Selbstverständlich kann der transparente Bereich 130 auch eine Aussparung oder lediglich eine planparallele Platte sein, wobei dann zu Abbildung des Bauelements 160 auf den CMOS-Sensor 140 eine zusätzliche Abbildungsoptik erforderlich wäre.

Zusammenfassend bleibt festzustellen: Die Erfindung schafft eine Beleuchtungsvorrichtung 100, welche eine Mehrzahl von Leuchtelementen 111 zum Aussenden von Beleuchtungslicht 112 und ein optisches Element 120 zum Lenken des Beleuchtungslichtes 112 auf einen vorgegebenen Messbereich 150 aufweist. Das optische Element 120 umfasst ein diffus streuendes Material und weist eine Strukturierung 123 auf, welche derart ausgebildet ist, dass das ausgesandte Beleuchtungslicht 112 gezielt auf den Messbereich 150 gelenkt wird. Das optische Element 120 dient der Fokussierung und der Homogenisierung des Beleuchtungslichts, so dass im Ergebnis das Objekt 160 unter einer Vielzahl von verschiedenen Winkeln beleuchtet werden kann. Die durch die Strukturierung 125 hervorgerufene Fokussierung des Beleuchtungslichts 112 beruht auf Refraktionseffekten an verschiedenen kleinen Grenzflächen der Strukturierung bzw. auf Interferenzeffekten zwischen verschiedenen Teilstrahlen des von einem Leuchtelement 111 ausgesandten Beleuchtungslichts 112. Bevorzugt weist das optische Element 120 einen transparenten Bereich 130 auf, so dass durch das optische Element 120 hindurch ein Abbildungsstrahlengang zwischen dem Objekt 160 und einer Kamera entlang einer optischen Achse 125 geführt werden kann, auf welcher an einer der dem Objekt gegenüberliegenden Seite ein Kamerasensor 170 angeordnet ist.

### Bezugszeichenliste

- 100: Beleuchtungsvorrichtung
- 110: Platine
- 111: LED
- 112: Beleuchtungslicht
- 115: Aussparung
- 120: optisches Element
- 121: Oberseite
- 122: Unterseite
- 123: Strukturierung
- 125: optische Achse
- 127: Beleuchtungskegel
- 130: transparenter Bereich
- 131: gewölbte Oberseite
- 132: untere Grenzfläche
- 150: Messbereich
- 160: Bauelement
- 161: Sauggreifer
- 170: CMOS-Sensor

## Patentansprüche

1. Vorrichtung zum homogenen Beleuchten von einem in einer Objektebene angeordneten Objekt, insbesondere einem elektronischen Bauelement und/oder einer auf einem Bauelementeträger aufgebrachten Markierung, mit
• einer Mehrzahl von Leuchtelementen (111), eingerichtet zum Aussenden von Beleuchtungslicht (112), und
• einem optischen Element (120) zum Lenken des Beleuchtungslichts (112) auf einen vorgegebenen Messbereich (150) in der Objektebene,
wobei das optische Element (120)
- ein diffus streuendes Material umfasst und
- eine Strukturierung (123) aufweist, welche derart ausgebildet ist, das das von den Leuchtelementen (111) ausgesandte Beleuchtungslicht (112) gezielt auf den Messbereich (150) lenkbar ist.

2. Vorrichtung nach Anspruch 1, bei der das optische Element (120) einstückig aus einem diffus streuenden Material hergestellt ist.

3. Vorrichtung nach einem der Ansprüche 1 bis 2, bei der die Strukturierung (123) durch eine Variation der Dicke des optischen Elements (120) realisiert ist.

4. Vorrichtung nach einem der Ansprüche 1 bis 3, bei der die Strukturierung durch eine Variation des lokalen Brechungsindexes des optischen Elements (120) realisiert ist.

5. Vorrichtung nach einem der Ansprüche 1 bis 4, bei der die Leuchtelemente (111) in einer Ebene angeordnet sind.

6. Vorrichtung nach einem der Ansprüche 1 bis 5, bei der
• das optische Element (120) eine zu einer optischen Achse (125) symmetrische Form aufweist und
• die Leuchtelemente (111) symmetrisch zu der optischen Achse (125) angeordnet sind.

7. Vorrichtung nach einem der Ansprüche 1 bis 6, bei der das optische Element (120) einen transparenten Bereich (130) aufweist.

8. Vorrichtung nach Anspruch 7, bei der der transparente Bereich
• eine Aussparung
• eine planparallele Platte oder
• eine Abbildungsoptik (130) ist.
